Europäisches Patentamt

European Patent Office

Office européen des brevets

(11) Numéro de publication: **0 172 042**
**B1**

(19)

## (12) FASCICULE DE BREVET EUROPEEN

(45) Date de publication du fascicule du brevet:
07.12.88

(51) Int. Cl.⁴: **H 03 G 3/34,** H 03 G 3/20,
H 04 N 5/38

(21) Numéro de dépôt: 85401150.9

(22) Date de dépôt: 11.06.85

(54) **Dispositif pour limiter la puissance d'émission d'émetteurs d'ondes radioélectriques.**

(30) Priorité: 18.06.84 FR 8409479

(43) Date de publication de la demande:
19.02.86 Bulletin 86/8

(45) Mention de la délivrance du brevet:
07.12.88 Bulletin 88/49

(84) Etats contractants désignés:
AT BE CH DE GB IT LI LU NL SE

(56) Documents cités:
DE-A- 2 618 524
US-A- 4 434 440

THE RADIO AND ELECTRONIC ENGINEER, vol. 3, no. 5,
mai 1973, pages 341-347, Londres, GB; W. GOSLING:
"Impulsive noise reduction in radio receivers"
MICROWAVE JOURNAL, vol. 18, no. 7, juillet 1975,
pages 35-37, 44, Dedham, US; G. BERRETTA et al.:
"Predicting amplifer performance for multicarriers"

(73) Titulaire: THOMSON-LGT LABORATOIRE GENERAL
DES TELECOMMUNICATIONS, 51, boulevard de la
République, F-78400 Chatou (FR)

(72) Inventeur: Allanic, Michel, THOMSON-CSF SCPI 173, bld
Haussmann, F-75379 Paris Cedex 08 (FR)
Inventeur: Cluniat, Claude, THOMSON-CSF
SCPI 173, bld Haussmann, F-75379 Paris Cedex 08 (FR)

(74) Mandataire: Lincot, Georges et al, THOMSON-CSF
SCPI 19, avenue de Messine, F-75008 Paris (FR)

ACTORUM AG

# Description

La présente invention concerne un dispositif pour limiter la puissance d'émission d'ondes radioélectriques.

Elle trouve plus particulièrement son application dans les dispositifs destinés à empêcher tout dépassement de puissance à l'intérieur des chaînes d'amplification d'émetteurs radioélectriques, ces chaînes étant elles-mêmes équipées de systèmes de régulation de gain ainsi que les systèmes de régulation de la puissance de sortie des réémetteurs.

Pour limiter la puissance de sortie des émetteurs d'ondes radioélectriques il est connu d'utiliser des étages limiteurs de puissance qui précèdent généralement la chaîne d'amplification de puissance, ces étages limiteurs étant commandés à partir d'un détecteur de dépassement du niveau du signal par rapport à un seuil prédéterminé, ce détecteur étant situé en aval ou en amont de la chaîne d'amplification. Aussi perfectionnés que sont ces dispositifs aucun de ceux-ci ne donne entière satisfaction et des dépassements de puissance de courte durée généralement de quelques microsecondes, ont toujours lieu, ces dépassements apparaissant par exemple à la mise en route des chaînes d'amplification, lors des coupures accidentelles de courte durée intervenant sur l'alimentation des émetteurs ou encore lors des déconnections accidentelles des antennes d'émission de leurs chaînes d'amplification. Naturellement ces dépassements de puissance aussi court soient ils dans le temps sont généralement néfastes au fonctionnement des chaînes d'amplification et peuvent entraîner des détériorations de certains composants à semi-conducteur ou des tubes électroniques constituant les chaînes d'amplification.

Le but de l'invention est de pallier les inconvénients précités.

A cet effet, l'invention a pour objet, un dispositif pour limiter la puissance d'émission d'un émetteur d'ondes radioélectriques pourvu d'une chaîne d'amplification du signal radioélectrique à émettre, comprenant un étage limiteur pour atténuer le signal électrique à amplifier avant de l'appliquer à l'entrée de la chaîne d'amplification, un coupleur pour prélever au moins une partie du signal à amplifier, caractérisé en ce qu'il comporte un dispositif retardateur couplé entre le coupleur et l'étage limiteur pour retarder le signal à amplifier sortant du coupleur avant de l'appliquer à l'entrée de l'étage limiteur, ainsi que des moyens de commande couplés entre le coupleur et les entrées de commande de l'étage limiteur pour bloquer l'étage limiteur et empêcher la transmission du signal à amplifier à l'entrée de la chaîne d'amplification lorsque le niveau du signal à amplifier dépasse un seuil d'amplitude prédéterminée et pour maintenir le blocage de l'étage limiteur, après que le niveau du signal amplifié soit redescendu en-dessous du seuil prédéterminé, durant un temps suffisant pour que le signal retardé par le dispositif retardateur et parvenant à l'entrée de l'étage limiteur ne puisse être amplifié par la chaîne d'amplification lorsque son niveau dépasse encore le seuil d'amplitude prédéterminée.

D'autres caractéristiques et avantages de l'invention apparaîtront plus clairement à l'aide de la description qui va suivre faite au regard des dessins annexés qui représentent:

les figures 1 et 2 des dispositifs limiteurs de puissance de l'art antérieur;

la figure 3 le schéma de principe du dispositif limiteur de puissance selon l'invention;

les figures 4 et 5 des graphes des temps représentant le fonctionnement du dispositif selon l'invention en l'absence du dispositif retardateur placé entre l'entrée du dispositif et l'étage limiteur;

la figure 6 un graphe des temps montrant le fonctionnement du dispositif selon l'invention en présence du dispositif retardateur placé entre l'entrée du dispositif et l'entrée de l'étage limiteur;

la figure 7 un graphe des temps représentant le fonctionnement du dispositif selon l'invention muni d'un dispositif retardateur situé entre l'entrée du dispositif et l'étage limiteur et d'un moyen de commande comprenant un dispositif de maintien de l'information de dépassement pour bloquer l'étage limiteur durant le temps suffisant pour que l'information de dépassement sortant du dispositif retardateur ne puisse avoir aucun effect sur l'entrée de la chaîne d'amplification de puissance;

la figure 8 un schéma d'un émetteur de puissance muni du dispositif de limitation de puissance selon l'invention;

la figure 9 un schéma d'un réémetteur de puissance muni d'un dispositif limiteur de puissance selon l'invention;

la figure 10 un schéma détaillé du dispositif selon l'invention.

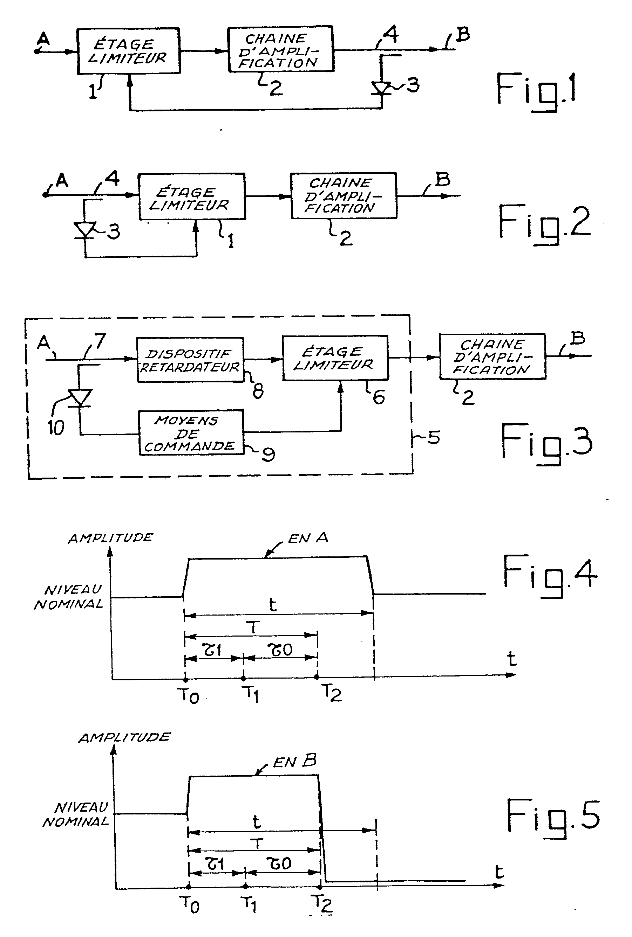

Des dispositifs limiteurs de puissance pour chaînes d'amplification, appartenant à l'état de la technique, sont représentés schématiquement aux figures 1 et 2, ces dispositifs étant constitués par des étages limiteurs 1 placés à l'entrée de chaînes d'amplification 2, les étages limiteurs étant commandés par des détecteurs de dépassement 3 ayant des entrées couplées à l'entrée ou à la sortie des chaînes d'amplification au moyen de coupleurs 4.

Sur la figure 1 lorsque le niveau du signal de sortie de la chaîne d'amplification 2 dépasse un seuil d'amplitude prédéterminée, le détecteur de dépassement 3 commande l'étage limiteur 1 pour atténuer le niveau du signal appliqué à l'entrée A de la chaîne d'amplification au travers de l'étage limiteur 1. Ce dispositif a pour inconvénient qu'il ne permet pas de limiter totalement la transmission du signal lorsque son niveau dépasse le seuil d'amplitude prédéterminée par le détecteur 3, du fait que nécessairement le détecteur 3 ne peut agir qu'à un instant qui est retardé par rapport à l'instant d'apparition du dépassement du signal au-dessus du seuil d'amplitude prédéterminée, ce temps correspondant au temps de transit du signal depuis l'entrée A de l'étage limiteur 1 jusqu'à la sortie B de la chaîne d'amplification 2. Ce temps doit de plus être augmenté du temps de réaction de l'étage limiteur au dépassement du signal, de sorte que le temps de dépassement constaté à la sortie B de la chaîne d'amplification correspond à l'addition des temps de transit et de réponse, de l'étage limiteur 1, de la chaîne d'amplification 2 et du détecteur de dépassement 3.

Dans le cas de la figure 2 le détecteur de dépassement 3 agit au moyen du coupleur 4 sur le signal d'entrée appliqué à l'entrée de l'étage limiteur 1. Cette disposition apparaît plus efficace puisqu'il n'y a pas l'inconvénient rencontré à la figure 1 dû au temps de transit du signal au travers de l'étage limiteur 1 et de la chaîne d'amplification 2. Malheureusement on constate généralement que le temps de transit entre l'entrée A et la sortie B de l'étage limiteur de la chaîne d'amplification placée en série est nettement plus court que le temps de réponse de l'étage limiteur, de sorte qu'un signal présentant un niveau plus grand que le seuil de dépassement prédéterminé est malgré tout amplifié pendant un court instant par la chaîne formée par l'étage limiteur et la chaîne d'amplification, cet instant correspondant au temps d'action de l'étage limiteur.

Le dispositif selon l'invention qui est représenté par le schéma de principe sur la figure 3 à l'intérieur d'un rectangle en pointillés 5 permet de remédier à ces inconvénients. Il comprend, comme dans les cas des figures 1 et 2, un étage limiteur 6 placé à l'entrée de la chaîne d'amplification 2 ainsi que, comme dans le cas de la figure 2, un coupleur 7 pour prélever au moins une partie du signal à amplifier, ce signal étant appliqué à l'entrée de la chaîne d'amplification au travers de l'étage limiteur 6. A la différence avec la figure 2, un dispositif retardateur 8 de constante de retard $\tau_2$ relie le coupleur 7 à l'entrée de l'étage limiteur 6 et des moyens de commande 9 agissent sur les entrées de commande de l'étage limiteur 6 à partir d'une information de dépassement fournie par un détecteur de dépassement 10 relié au coupleur 7.

Le fonctionnement du dispositif de la figure 3 est analysé ci-après, selon une première hypothèse consistant à négliger l'influence du retard $\tau_2$ et selon une deuxième hypothèse faisant intervenir l'influence du retard $\tau_2$ dans la transmission du signal depuis le point A jusqu'au point B.

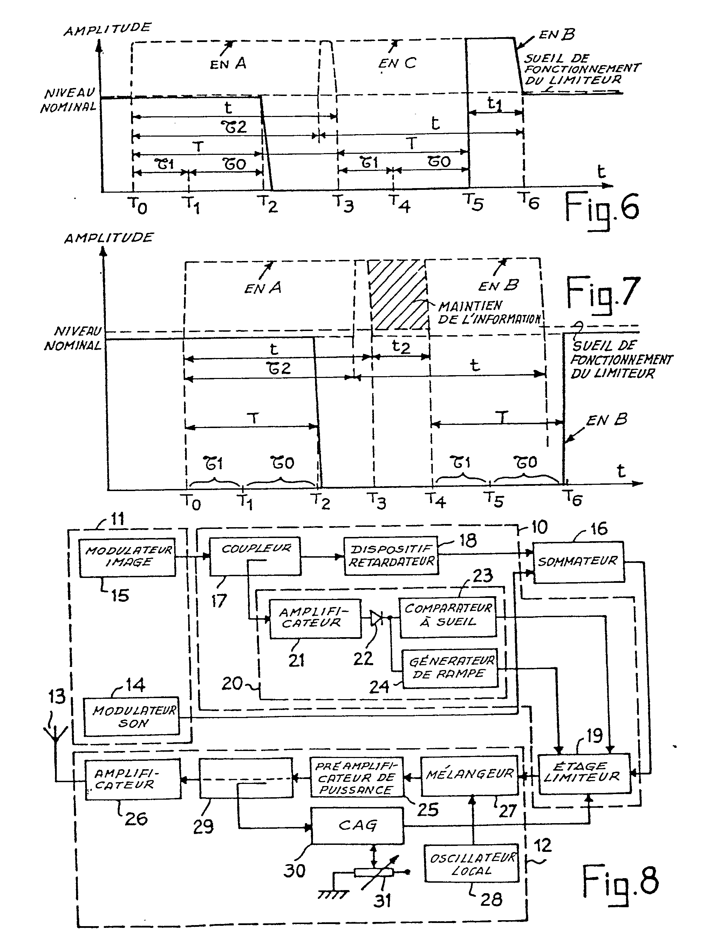

L'illustration du fonctionnement en l'absence du retard $\tau_2$ est représentée aux figures 4 et 5 qui font apparaître à partir d'un instant $T_0$ un dépassement du signal appliqué à l'entrée A du dispositif au-dessus du niveau nominal de fonctionnement. Le signal en A est prélevé par le coupleur 7 et est transmis à l'étage limiteur 6 avec un retard $\tau_1$ correspondant au temps de réponse des moyens de commande 9 et l'étage limiteur 6 répond à la sollicitation des moyens de commande 9 après un retard $\tau_0$ correspondant au temps de réponse de l'étage limiteur 6. Le signal transmis vers la sortie B de la chaîne d'amplification n'est limité dans ces conditions qu'au bout d'un instant T égal à la somme des constantes de retard $\tau_1$ et $\tau_0$ des moyens de commande 9 et de l'étage limiteur 6. Dans ces conditions si la durée t du dépassement du signal présent au point A au-dessus de son niveau nominal est inférieure à la durée T, l'étage limiteur 6 n'a aucune action sur le signal présent au point B en sortie de la chaîne d'amplification 2 et dans ce cas un dépassement de puissance a lieu pendant toute la durée t du dépassement du signal au point A. Par contre, si comme le montre la figure 5 la durée du dépassement t est supérieure au temps T, l'étage limiteur a une action sur le signal obtenu au point B en sortie de la chaîne d'amplification à un instant $T_2$ séparé du temps $T_0$ d'apparition du dépassement de l'intervalle de temps T, toutefois durant l'intervalle de temps $T = \tau_1 + \tau_0$ l'étage limiteur reste totalement inopérant.

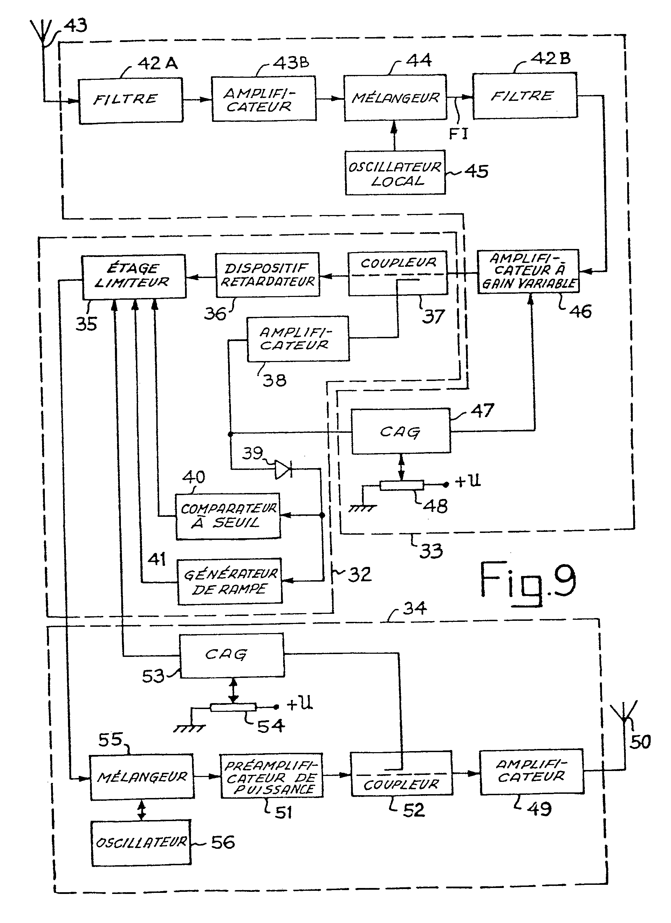

Le fonctionnement du dispositif apparaît très différent si le retard $\tau_2$ du dispositif retardateur 8 devient significatif et en fixant, par exemple, le retard $\tau_2$ à une valeur qui est plus grande ou égale à la somme des retards $\tau_1 + \tau_0$, la réponse du dispositif à un dépassement d'amplitude du signal d'entrée devient celle qui est représentée à la figure 6 pendant les instants élémentaires $T_0$, $T_1$ et $T_2$, correspondant à la période T. Le front montant du signal arrivant en A et traversant le dispositif retardateur 8 n'arrive pas encore à l'entrée C de l'étage limiteur 6 à la fin de l'instant $T_2$ pour lequel la commande de verrouillage de l'étage limiteur 6 est effectivement réalisée, le verrouillage de l'étage limiteur est maintenu, après un instant $T_3$ marquant l'instant de retombée du signal appliqué au point A à son niveau normal, pendant une autre période de temps T correspondant à nouveau au temps de désactivation de l'étage limiteur 6 jusqu'à l'instant $T_5$. Cependant si à l'instant $T_5$, le signal sortant du dispositif retardateur 8 et appliqué au point C à l'entrée de l'étage limiteur 6, dépasse encore le niveau nominal, le dispositif de la figure 3 ne peut arrêter la progression du signal au travers de la chaîne d'amplification et pendant une durée $\tau_1$ allant de l'instant $T_5$ à l'instant $T_6$ sur la figure 6, un dépassement de puissance a lieu. Ce dépassement peut être évité si les moyens de commande comprennent un dispositif pour maintenir l'information de dépassement au-delà de la durée du temps t de dépassement du signal au point A ce maintien étant déterminé par exemple, de manière à durer pendant un intervalle de temps $t_2$ choisi tel que $t_2$ soit plus grand que la durée t de dépassement du signal présent sur l'entrée A du dispositif augmentée de la durée $t_1$ précédemment définie. On choisira par exemple une valeur $t_2$ telle que la relation $t_2 \geqq t + \tau_2 - (\tau_1 + \tau_0)$ soit vérifiée. Lorsque cette condition est réalisée les instants $T_4$, $T_5$ et $T_6$ précédemment définis sur la figure 6 sont alors majorés de l'intervalle de temps $t_2$ de la manière représentée à la figure 7.

Un exemple d'application du dispositif selon l'invention à la réalisation d'une chaîne d'amplification d'un émetteur de télévision est maintenant décrit à l'aide de la figure 8 qui représente à l'intérieur d'un rectangle en pointillés 10 un dispositif limiteur de puissance selon l'invention inséré entre une source 11 d'émission de signaux de télévision et une chaîne d'amplification 12 de signaux de télévision couplée en sortie à un aérien 13. La source 11 d'émission des signaux de télévision comprend, de façon connue, un modulateur de son 14 et un modulateur d'image 15. La sortie du modulateur de son 14 est reliée à une première entrée d'un sommateur 16 dont la deuxième entrée est reliée à la sortie du modulateur d'image 15 au travers du dispositif limiteur de puissance 10 de l'invention. Le dispositif limiteur 10 comprend, comme dans le cas du dispositif décrit à la figure 3, un coupleur 17, un dispositif retardateur 18, un étage limiteur 19 commandé par les moyens de commande 20 représenté à l'intérieur d'une ligne en pointillés, et constitué par un amplificateur 21, un détecteur 22 et un comparateur à seuil 23 tous les trois reliés en série, et un générateur de rampe 24 disposé entre une entrée de commande de l'étage limiteur 19 et la sortie du détecteur 22. L'entrée des moyens de commande 20 est constituée par l'entrée de l'amplificateur 21 qui est relié, de manière similaire aux moyens de commande 9 de la figure 3, au coupleur 17 de façon à prélever au moins une partie du signal d'entrée fourni par le modulateur d'image 15 à l'entrée de l'amplificateur 21, pour l'amplifier et l'acheminer par l'intermédiaire du détecteur 22 à l'entrée du comparateur à seuil 23. Le comparateur à seuil 23 agit directement sur une entrée de commande de l'étage limiteur 19 pour interdire le transfert du signal sortant du sommateur 16 vers la chaîne d'amplification lorsque le niveau du signal prélevé par le coupleur 17 dépasse le seuil de comparaison prédéterminé à l'intérieur du comparateur à seuil 23. La chaîne d'amplification 12 est constituée de façon connue par un préamplificateur de puissance 25, suivi d'un amplificateur de puissance 26. Elle comprend un étage mélangeur 27 pour moduler un signal porteur fourni par l'oscillateur local 28 par le signal vidéo fourni à la sortie de l'étage limiteur 19. Il comprend également une chaîne de régulation pour stabiliser le gain de l'amplificateur, cette chaîne de régulation étant constituée de façon connue par un coupleur 29 relié entre la sortie du préamplificateur de puissance 25 et l'amplificateur 26, un dispositif de contrôle de gain automatique (CAG) 30 couplé entre le coupleur 29 et une entrée de commande de l'étage limiteur 19, pour permettre le réglage du taux d'atténuation de l'étage limiteur 19 en fonction du niveau du signal amplifié par le préamplificateur de puissance 25. Le taux de contre-réaction est contrôlé de façon connue par un potentiomètre réglable 31 qui agit sur le dispositif de contrôle de gain automatique 30 de manière à fixer le taux de contre-réaction de la boucle ainsi réalisée à une valeur déterminée. Le générateur de rampe 24 permet une activation lente de l'étage limiteur 19 lors de sa remise en fonctionnement progressive après tout blocage occasionné par un dépassement du signal vidéo au-dessus de son amplitude nominale.

Un exemple d'application du dispositif selon l'invention à la réalisation d'un réémetteur de signaux de télévision est maintenant décrit à l'aide du schéma représenté à la figure 9. Le dispositif selon l'invention est représenté sur la figure 9 à l'intérieur d'une ligne en pointillés 32 et est situé entre une chaîne de réception 33 et une chaîne d'émission 34. Le dispositif représenté à l'intérieur de la ligne en pointillés 32 comprend comme dans le cas de la figure 8 un étage limiteur 35, un dispositif retardateur 36 et un coupleur 37 reliés dans cet ordre en série, il comprend également un amplificateur 38, un détecteur 39 et un comparateur à seuil 40 couplés entre une sortie du coupleur 37 et une entrée de commande de l'étage limiteur 35 ainsi qu'un générateur de rampe 41 relié à la sortie du détecteur 39 pour commander d'une façon progressive l'étage limiteur 35. La partie réception 33 du réémetteur représenté à la figure 9 comprend de façon connue un filtre d'entrée 42 A couplé par son entrée à une antenne de réception 43 et couplé par sa sortie à l'entrée d'un amplificateur 43 B. L'amplificateur 43 B est couplé à une entrée d'un mélangeur 44 excité sur une deuxième entrée par un oscillateur local 45 dans le but de transformer la fréquence porteuse des signaux de télévision reçus sur l'antenne 43 en une fréquence intermédiaire FI. Le signal de fréquence intermédiaire FI est appliqué par la sortie du mélangeur 44 à l'entrée du coupleur 37 du dispositif limiteur 32 de l'invention au travers d'un amplificateur à gain variable 46 contrôlé par un dispositif de contrôle de gain automatique 47 dont les paramètres d'atténuation sont réglés à l'aide d'un potentiomètre 48. Le dispositif d'émission 34 comprend de façon connue une chaîne d'amplification constituée par un amplificateur de puissance 49 agissant sur une antenne d'émission 50 et amplifiant les signaux fournis par un préamplicateur de puissance 51 relié à l'entrée de l'amplificateur 49 au travers d'un coupleur 52. Le coupleur 52 est relié au moyen d'un dispositif de contrôle de gain automatique 53 à une troisième entrée de commande de l'étage limiteur 35 du dispositif selon l'invention pour régler l'étage limiteur 35 à son atténuation maximum lors de la mise sous tension du réémetteur de la figure 9 et empêcher pas conséquent toute amplification de puissance par la chaîne d'amplification constituée par les amplificateurs 49 et 51 durant la période transitoire de mise en route de l'installation.

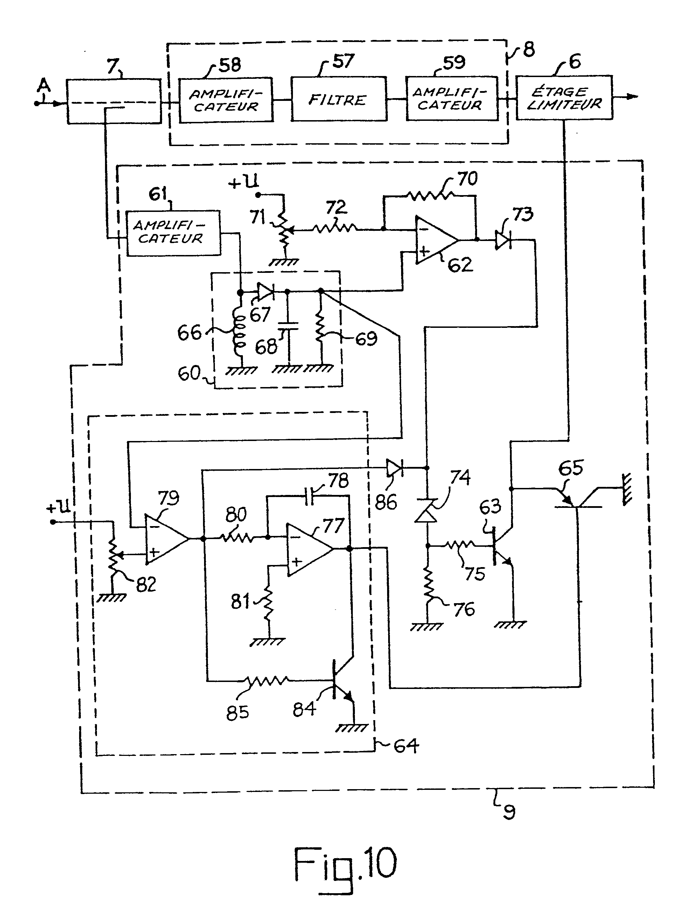

Une représentation plus détaillé du dispositif selon l'invention qui vient d'être décrit à l'aide de la figure 3 et dont les applications sont montrées aux figures 8 et 9, est maintenant décrite à l'aide de l'exemple de réalisation de la figure 10. Sur la figure 10, le dispositif retardateur 8 représenté à l'intérieur d'une ligne en pointillés comprend un filtre à onde de surface 57 compris entre deux amplificateurs 58 et 59. Les moyens de commande 9 représentés également à l'intérieur d'une ligne en pointillés comprennent un détecteur de signal 60 couplé à une sortie du coupleur 7 au travers d'un amplificateur 61, un amplificateur comparateur 62 dont la sortie est couplée à l'entrée d'un transistor bloqueur 63 du circuit de l'étage limiteur 6 constitué éventuellement par un atténuateur électronique à diodes PIN, un générateur de rampe 64 représenté à l'intérieur d'une ligne en pointillés, ainsi qu'un transistor 65 de blocage de l'étage limiteur 6 à la mise en route des circuits d'amplification. Le détecteur 60 comprend une inductance 66 couplée entre la sortie de l'amplificateur 61 et la masse générale des circuits du dispositif représenté à la figure 10, une diode détectrice 67 branchée par son anode à la sortie de l'amplificateur 61 et par sa cathode à une extrémité d'un condensateur 68 dont l'autre extrémité est reliée à la masse générale du circuit de la figure 10, ainsi qu'une résistance 69 de très forte valeur. La diode 67 permet la charge rapide du condensateur 68 par le signal fourni par la sortie de l'amplificateur 61 lorsque le potentiel de son anode est supérieur au potentiel de sa cathode en permettant également une décharge lente du condensateur 68 au travers de la résistance 60 lorsque inversement le signal présent à la sortie de l'amplificateur 61 a un niveau inférieur au niveau de tension présent sur la cathode de la diode 67. Le comparateur 62 est constitué par un amplificateur opérationnel différentiel ayant une entrée «–» et une entrée «+», l'entrée «–» étant reliée d'une part à la sortie d l'amplificateur 62 au moyen d'une résistance 70 et d'autre part au curseur d'un potentiomètre 71 alimenté entre le potentiel du circuit de masse et une tension+U pour définir le potentiel de référence correspondant au seuil de dépassement du signal appliqué sur l'entrée A du dispositif. La sortie de l'amplificateur 62 est reliée à la base du transistor 63 au travers d'une diode 73, d'une diode Zener 74 et d'une résistance 75 reliées en série respectivement dans cet ordre entre la sortie de l'amplificateur 62 et la base du transistor 63. Les extrémités communes à la diode Zener 74 et à la résistance 75 sont reliées au circuit de masse du dispositif de la figure 10 au moyen d'une résistance 76. Le transistor 63 est monté en commutateur de courant, son émetteur est relié au circuit de masse du dispositif et son collecteur est relié à l'entrée de commande de l'étage limiteur 6. Le détecteur 60 et l'amplificateur comparateur 62 relié au transistor 63 déterminent la durée de maintien $t_2$ précédemment décrite, cette durée étant déterminée par la décharge du condensateur 68 au travers de la résistance 69 de forte valeur à partir du moment où le signal de dépassement capté par l'amplificateur 61 branché à la sortie du coupleur 7 détecte une retombée du signal de dépassement présent à l'entrée A du dispositif. Le générateur de rampe 64 est constitué de façon connue par un intégrateur, formé par un amplificateur opérationnel 77 ayant une entrée «—» et une entrée «+», l'entrée «–» étant reliée à la sortie de l'amplificateur opérationnel au moyen d'un condensateur 78 et à la sortie d'un détecteur de seuil 79 au moyen d'une résistance 80. L'entrée «+» de l'amplificateur 77 est reliée de façon connue à la masse générale du dispositif au moyen d'une résistance 81. Le détecteur de seuil 79 est formé par un amplificateur opérationnel ayant également une entrée «–» et une entrée «+», l'entrée «+» étant polarisée à une valeur de tension constante au moyen d'un potentiomètre 82 alimenté à ses extrémités par une tension continue +U. L'amplificateur 79 a son entrée «–» reliée à la sortie du détecteur 60 de manière à assurer la remise en route progressive de l'étage limiteur après tout blocage occasionné par un dépassement de signal au point A du dispositif. Un transistor 84 est relié par sa base à la sortie de l'amplificateur 79 au moyen d'une résistance 85, son collecteur est relié à la sortie de l'amplificateur 77 et son émetteur est relié à la masse générale du circuit de façon à réaliser la remise à zéro de l'intégrateur lorsque le niveau du signal à l'entrée A du dispositif redevient correct.

**Revendications**

1. Dispositif pour limiter la puissance d'émission d'un émetteur d'ondes radioélectriques pourvu d'une chaîne d'amplification (2, 12, 34) du signal radioélectrique à émettre, comprenant un étage limiteur (6, 19, 35) pour atténuer le signal électrique à amplifier avant de l'appliquer à l'entrée de la chaîne d'amplification (2, 12, 34), un coupleur (7, 17, 37) pour prélever au moins une partie du signal à amplifier, caractérisé en ce qu'il comporte un dispositif retardateur (8, 18, 36) couplé entre le coupleur (7, 17, 37) et l'étage limiteur (6, 19, 35) pour retarder le signal à amplifier sortant du coupleur (7, 17, 37) avant de l'appliquer à l'entrée de l'étage limiteur (6, 19, 35) ainsi que des moyens de commande (9, 20, 40) couplés entre le coupleur (7, 17, 37) et les entrées de commande de l'étage limiteur (6, 19, 35) pour bloquer l'étage limiteur (6, 19, 35) et empêcher la transmission du signal à amplifier à l'entrée de la chaîne d'amplification (2, 12, 34) lorsque le niveau du signal à amplifier dépasse un seuil d'amplitude prédéterminée et pour maintenir le blocage de l'étage limiteur (6, 19, 35), après que le niveau du signal à amplifier soit redescendu en-dessous du seuil prédéterminé, durant un temps $t_2$ suffisant pour que le signal retardé par le dispositif retardateur (8, 18, 36) et parvenant à l'entrée de l'étage limiteur (6, 19, 35) ne puisse être amplifié par la chaîne d'amplification (2, 12, 34) lorsque son niveau dépasse encore le seuil d'amplitude prédéterminée.

2. Dispositif selon la revendication 1, caractérisé en ce que le temps $t_2$ de blocage de l'étage limiteur (6) est déterminé pour que la relation $t_2 \geqq t + \tau_2 - (\tau_1 + \tau_0)$ soit vérifiée où t désigne la durée pendant laquelle le signal présent à l'entrée du coupleur (7, 17, 37) dépasse la valeur de seuil d'amplitude prédéterminée

$\tau_2$ désigne la constante de retard du dispositif retardateur (8, 18, 36)

$\tau_1$ désigne le retard de réaction des moyens de commande (9, 20, 40) à l'amplitude de dépassement du signal

$\tau_0$ désigne le retard de réaction de l'étage limiteur (6, 19, 35) à la sollicitation des moyens de
commande (9, 20, 40).

3. Dispositif selon les revendications 1 et 2, caractérisé en ce que le dispositif retardateur (8, 18,
36) est formé par un filtre à onde de surface.

4. Dispositif selon l'une quelconque des revendications 1 à 3, caractérisé en ce que l'étage limiteur (6, 12, 34) est constitué par un atténuateur
électronique à diodes PIN.

5. Dispositif selon l'une quelconque des revendications 1 à 4, caractérisé en ce que les moyens
de commande (9, 20, 40) comprennent un détecteur (60) pour stocker les amplitudes de dépassement du signal à amplifier couplé à un comparateur à seuil (62) pour bloquer l'étage limiteur (6,
19, 35) lorsque l'amplitude du signal à amplifier
dépasse un seuil prédéterminé.

6. Dispositif selon la revendication 5, caractérisé en ce que le détecteur (60) pour stocker les
amplitudes de dépassement du signal comprend
un condensateur (68) relié au coupleur (7) au travers au moins une diode (67) qui est passante
lorsque le niveau du signal obtenu du coupleur (7)
est plus grand que l'amplitude du signal stocké
dans le condensateur (68).

7. Dispositif selon la revendication 6, caractérisé en ce que le détecteur (60) pour stocker les
amplitudes de dépassement comprend des
moyens (69) de décharge lente du condensateur,
mis en action lorsque le niveau du signal obtenu
du coupleur (7) est inférieur à l'amplitude du signal stocké dans le condensateur.

8. Dispositif selon l'une quelconque des revendications 1 à 7, caractérisé en ce qu'il comprend
un générateur de rampe (77, 78) pour assurer une
remise en fonctionnement lente de l'étage limiteur (6) après tout blocage de l'étage limiteur (6)
lorsque l'amplitude du signal à amplifier est redescendue en-dessous du seuil prédéteminé.

9. Utilisation du dispositif selon l'une quelconque des revendications 1 à 8 pour limiter l'amplification en puissance d'une chaîne d'amplification d'un émetteur de télévision.

10. Utilisation du dispositif selon l'une quelconque des revendications 1 à 8 pour limiter l'amplification en puissance d'une chaîne d'amplification dans un réémeteur de télévision.

**Claims**

1. A device for limiting the transmission power
of a radio wave transmitter provided with an amplification cascade (2, 12 and 34) for the radio signal to be transmitted, comprising a limiting stage
(6, 19 and 35) in order to attenuate the electric
signal to be amplified prior to supplying it to the
input of the amplification cascade (2, 12 and 34),
a coupler (7, 17 and 37) to sample at least a part of
the signal to be amplified, characterized in that it
comprises a delay device (8, 18 and 36) coupled
between the coupler (7, 17 and 37) and the limiting stage (6, 19 and 35) in order to delay the signal to be amplified leaving the coupler (7, 17 and 37)
before feeding it to the input of the limiting stage
(6, 19 and 35), as well as control means (9, 20 and
40) coupled between the coupler (7, 17 and 37)
and the control inputs of the limiting stage (6, 19
and 35) in order to lock the limiting stage (6, 19
and 35) and to prevent the transfer of the signal
to be amplified to the input of the amplification
cascade (2, 12 and 34) when the level of the signal
to be amplified exceeds a predetermined amplitude threshold and to maintain locking of the limiting stage (6, 19 and 35) after the level of the
signal to be amplified has gone down below the
predetermined threshold during a time $t_2$ sufficient to prevent the signal delayed by the delaying device (8, 18 and 36) and arriving at the input
of the limiting stage (6, 19 and 35) from being amplified by the amplification cascade (2, 12 and 34)
if its level does not exceed the predetermined
amplitude threshold again.

2. The device as claimed in claim 1, characterized, in that the time $t_2$ of locking of the limiting
stage (6) is set so that the relation:
$t_2 \geqq T + \tau_2 - (\tau_1 + \tau_0)$ to be verified, wherein

t denotes the duration in which the signal present at the input of the coupler (7, 17 and 37) exceeds the value of the predetermined amplitude
threshold,

$\tau_2$ denotes the delay constant of the delay device (8, 18 and 36),

$\tau_1$ denotes the reaction delay of the control
means (9, 20 and 40) at the amplitude exceeded
by the signal,

$\tau_0$ denotes the reaction delay of the limiting
stage (6, 19 and 35) in response to the control
means (9, 20 and 40).

3. The device as claimed in claims 1 and 2,
characterized in that delay device (8, 18 and 36) is
formed by a surface wave filter.

4. The device as claimed in any one of the
claims 1 through p3, characterized in that the limiting stage (6, 12 and 34) is constituted by an electronic attenuator with PIN diodes.

5. The device as claimed in any one of the
claims 1 through 4, characterized in that the control means (9, 20 and 40) comprise a detector (60)
to store the amplitudes exceeded by the signal to
be amplified coupled with a threshold comparator (62) to lock the limiting stage (6, 19 and 35)
when the amplitude of the signal to be amplified
exceeds a predetermined threshold.

6. The device as claimed in claim 5, characterized in that the detector (60) for storing the amplitudes exceeded by the signal comprises a capacitor (68) connected with the coupler (7) by way of
at least one diode (67) which is conducting when
the level of the signal obtained from the coupler
(7) is greater than the amplitude of the signal
stored in the capacitor (68).

7. The device as claimed in claim 6, characterized in that the detector (60) for storing the amplitudes exceeded by the signal comprises means
(69) for the slow discharge of the capacitor, put
into operation when the level of the signal obtained from the coupler (7) is less than the amplitude of the signal stored in the capacitor.

8. The device as claimed in any one of the claims 1 through 7, characterized in that it comprises a ramp generator (77 and 78) in order to ensure a slow re-starting of the limiting stage (6) after any locking thereof when the amplitude of the signal to be amplified has returned to a value under the predetermined threshold.

9. The use of the device as claimed in any one of the claims 1 through 8 to limit the power amplification of an amplification cascade of a television transmitter.

10. The use of the device as claimed in any one of the claims 1 through 8 to limit the power amplification of an amplification cascade in a television booster transmitter.

**Patentansprüche**

1. Vorrichtung zur Begrenzung der Sendeleistung eines Funkwellen-Senders, mit einer Verstärkungskette (2, 12, 34) für das auszusendende Funksignal versehen, die eine Begrenzungsstufe (6, 19, 35), um das zu verstärkende elektrische Signal zu dämpfen, bevor es an den Eingang der Verstärkungskette (2, 12, 34) angelegt wird, und einen Koppler (7, 17, 37) umfasst, um wenigstens einen Teil des zu verstärkenden Signals abzugreifen, dadurch gekennzeichnet, dass sie eine Verzögerungsvorrichtung (8, 18, 36), die zwischen den Koppler (7, 17, 37) und die Begrenzungsstufe (6, 19, 35) gekoppelt ist, um das aus dem Koppler (7, 17, 37) ankommende zu verstärkende Signal zu verzögern, bevor es an den Eingang der Begrenzungsstufe (6, 19, 35) angelegt wird, sowie Steuermittel (9, 20, 40) umfasst, welche zwischen den Koppler (7, 17, 37) und die Steuereingänge der Begrenzungsstufe (6, 19, 35) gekoppelt sind, um die Begrenzungsstufe (6, 19, 35) zu sperren und die Übertragung des zu verstärkenden Signals zum Eingang der Verstärkungskette (2, 12, 34) zu verhindern, wenn der Pegel des zu verstärkenden Signals eine vorbestimmte Amplitudenschwelle überschreitet, und um die Sperrung der Begrenzungsstufe (6, 19, 35) aufrechtzuerhalten, nachdem der Pegel des zu verstärkenden Signals unter die vorbestimmte Schwelle abgefallen ist, während einer Dauer $t_2$, die ausreicht, damit das durch die Verzögerungsvorrichtung (6, 19, 35) verzögerte Signal, das zum Eingang der Begrenzungsstufe (2, 12, 34) gelangt, durch die Verstärkungskette (2, 12, 34) nicht verstärkt werden kann, wenn sein Pegel die vorbestimmte Amplitudenschwelle noch überschreitet.

2. Vorrichtung nach Anspruch 1, dadurch gekennzeichnet, dass die Dauer $t_2$ zum Sperren der Begrenzungsstufe (6) so bestimmt ist, dass die Beziehung $t_2 \geq t + \tau_2 - (\tau_1 + \tau_0)$ erfüllt ist, worin

$t$ die Dauer bezeichnet, während welcher das am Eingang des Kopplers (7, 17, 37) vorhandene Signal den Wert der vorbestimmten Amplitudenschwelle überschreitet,

$\tau_2$ die Verzögerungskonstante der Verzögerungsvorrichtung (8, 18, 36) bezeichnet,

$\tau_1$ die Zeitspanne bis zur Reaktion der Steuermittel (9, 20, 40) auf die Amplitudenüberschreitung des Signals bezeichnet und

$\tau_0$ die Reaktionsverzögerung der Begrenzungsstufe (6, 19, 35) auf die Erregung der Steuermittel (9, 20, 40) bezeichnet.

3. Vorrichtung nach den Ansprüchen 1 und 2, dadurch gekennzeichnet, dass die Verzögerungsvorrichtung (8, 18, 36) aus einem Oberflächenwellenfilter besteht.

4. Vorrichtung nach einem der Ansprüche 1 bis 3, dadurch gekennzeichnet, dass die Begrenzungsstufe (6, 12, 34) aus einem elektronischen PIN-Dioden-Dämpfungsglied besteht.

5. Vorrichtung nach einem der Ansprüche 1 bis 4, dadurch gekennzeichnet, dass die Steuermittel (9, 20, 40) einen Detektor (60) umfassen, der die Überschreitungsamplituden des zu verstärkenden Signals speichert, und an einen Schwellenkomparator (62) angekoppelt ist, um die Begrenzungsstufe (6, 19, 35) zu sperren, wenn die Amplitude des zu verstärkenden Signals eine vorbestimmte Schwelle überschreitet.

6. Vorrichtung nach Anspruch 5, dadurch gekennzeichnet, dass der Detektor (60) zum Speichern der Überschreitungsamplituden des Signals einen Kondensator (68) umfasst, der mit dem Koppler (7) über wenigstens eine Diode (67) verbunden ist, welche leitend ist, wenn der Pegel des aus dem Koppler (7) erhaltenen Signals grösser als die Amplitude des in dem Kondensator gespeicherten Signals ist.

7. Vorrichtung nach Anspruch 6, dadurch gekennzeichnet, dass der Detektor (60) zum Speichern der Überschreitungsamplituden Mittel (69) zum langsamen Entladen des Kondensators umfasst, welche bestätigt werden, wenn der Pegel des aus dem Koppler (7) erhaltenen Signals kleiner als die Amplitude des in dem Kondensator gespeicherten Signals ist.

8. Vorrichtung nach einem der Ansprüche 1 bis 7, dadurch gekennzeichnet, dass sie einen Rampengenerator (77, 78) umfasst, um eine langsame Neuinbetriebnahme der Begrenzungsstufe (6) nach jedem Sperren der Begrenzungsstufe (6) zu gewährleisten, wenn die Amplitude des zu verstärkenden Signals unter die vorbestimmte Schwelle abgesunken ist.

9. Verwendung der Vorrichtung nach einem der Ansprüche 1 bis 8, um die Leistungsverstärkung einer Verstärkungskette eines Fernsehsenders zu begrenzen.

10. Verwendung der Vorrichtung nach einem der Ansprüche 1 bis 8, um die Leistungsverstärkung einer Verstärkungskette in einem Fernseh-Relais-Sender zu begrenzen.

A ——→ | ÉTAGE LIMITEUR | ——→ | CHAINE D'AMPLI-FICATION | —4—→ B

1         2     3

**Fig.1**

A —4—→ | ÉTAGE LIMITEUR | ——→ | CHAINE D'AMPLI-FICATION | ——→ B

3     1         2

**Fig.2**

A —7—→ | DISPOSITIF RETARDATEUR | ——→ | ÉTAGE LIMITEUR | ——→ | CHAINE D'AMPLI-FICATION | ——→ B

10     8     6     2

| MOYENS DE COMMANDE | 9

5

**Fig.3**

AMPLITUDE

EN A

NIVEAU NOMINAL

$t$

$T$

$\tau 1$    $\tau 0$

$T_0$    $T_1$    $T_2$     $t$

**Fig.4**

AMPLITUDE

EN B

NIVEAU NOMINAL

$t$

$T$

$\tau 1$    $\tau 0$

$T_0$    $T_1$    $T_2$     $t$

**Fig.5**

9

AMPLITUDE

EN A

EN C

EN B

SUEIL DE
FONCTIONNEMENT
DU LIMITEUR

NIVEAU
NOMINAL

t

τ2

t1

t

T

T

τ1

τ0

τ1

τ0

T0   T1      T2       T3    T4      T5    T6    Fig.6

AMPLITUDE

EN A

MAINTIEN
DE L'INFORMATION

EN B

Fig.7

NIVEAU
NOMINAL

SUEIL DE
FONCTIONNEMENT
DU LIMITEUR

t

τ2

t2

t

T

EN B

T

τ1

τ0

τ1

τ0

T0   T1      T2   T3    T4   T5         T6

11

MODULATEUR
IMAGE
15

COUPLEUR
17

DISPOSITIF
RETARDATEUR
18

10

16
SOMMATEUR

23

AMPLIFI-
CATEUR
21

COMPARATEUR
À SUEIL

22

GÉNÉRATEUR
DE RAMPE
24

20

13

14
MODULATEUR
SON

19

AMPLIFI-
CATEUR
26

29

PRÉ AMPLIFI-
CATEUR DE
PUISSANCE

MÉLANGEUR
25      27

ÉTAGE
LIMITEUR

CAG

30

31

OSCILLATEUR
LOCAL
28

12

Fig.8

11

Fig.9

Fig.10